# FASCICULE DE BREVET EUROPEEN

(11) **EP 1 052 680 B1**
(45) Date de publication et mention de la délivrance du brevet: **03.01.2007**
(21) Numéro de dépôt: 00400835.5
(22) Date de dépôt: 27.03.2000
(51) Int. Cl.: H01J 49/14, H01J 3/02

(54) **Générateur impulsionnel d'électrons**
Gepulster Elektronenstrahlgenerator
Pulse mode electron generator

(30) Priorité: 22.04.1999 FR 9905087
(43) Date de publication de la demande: 15.11.2000
(73) Titulaire: ALCATEL, 75008 Paris (FR)
(72) Inventeur: Pierrejean, Didier, 74370 Villaz (FR)
(74) Mandataire: Lamoureux, Bernard

(56) Documents cités:
- FR-A- 2 734 076
- C.CURTIS ET AL.: "spacecraft mass spectrometer ion source employing field emission cathodes" REVIEW SCIENTIFIC INSTRUMENTS, vol. 57, no. 5, mai 1986 (1986-05), pages 989-990, XP002123493
- E.POLLARD ET AL.: "ELECTRON-IMPACT IONIZATION TIME-OF-FLIGHT MASS SPECTROMETER FOR MOLECULAR BEAMS" REVIEW OF SCIENTIFIC INSTRUMENTS, vol. 58, no. 1, janvier 1987 (1987-01), pages 32-37, XP002123494

## Description

La présente invention concerne les générateurs d'électrons comprenant une cathode à émission de champ à micropointes émettrices d'électrons associées à une grille polarisée par des moyens de polarisation positive de grille, avec une anode attirant les électrons émis par la cathode.

Comme générateur d'électrons, on a développé depuis quelques années des cathodes à émission de champ à micropointes émettrices d'électrons (voir par exemple le document FR 2 734 076A), dans lesquelles des micropointes conductrices de l'électricité sont réalisées sur un substrat conducteur approprié et encastrées dans des cavités d'une couche isolante recouvrant le substrat, avec leur extrémité venant en affleurement d'une grille polarisée positivement et comportant des ouvertures au regard de chaque cavité. La forme acérée des sommets des micropointes produit un effet d'amplification locale de champ électrique qui favorise l'émission des électrons à température ambiante et permet d'obtenir cette émission à partir d'une tension de seuil de l'ordre de 50 à 100 volts en fonction de la constitution du réseau de micropointes.

De telles cathodes à émission de champ présentent notamment un bon rendement énergétique, meilleur que celui d'une source d'électrons traditionnelle sous forme d'un filament de tungstène chauffé entre 1 000 et 2 000°C et produisant une émission d'électrons par effet thermoélectronique. On sait que la puissance mise en jeu pour émettre les électrons est de l'ordre de 10 watts pour un filament de tungstène chauffé, alors que cette puissance est de l'ordre de 0,2 watts pour une cathode à émission de champs.

Un autre avantage des cathodes à émission de champ est leur rapidité de réaction, aussi bien en début d'émission d'électrons qu'en fin d'émission.

Dans les dispositifs connus, au cours des étapes de repos ou de non émission d'électrons, la grille est polarisée par une tension nulle, c'est-à-dire qu'elle se trouve au potentiel de la cathode. Au cours des étapes d'émission d'électrons, la grille est polarisée à une tension positive supérieure à la tension de seuil d'émission de la cathode.

Ces cathodes à émission de champ à micropointes émettrices d'électrons donnent satisfaction pour la génération d'électrons en régime continu ou en régime modulé à basse fréquence.

Dans certaines applications, par exemple pour les spectromètres de masse à temps de vol, on a besoin de générer un flux intermittent d'électrons sous forme de paquets d'électrons de durée la plus faible possible, de l'ordre de la nanoseconde, et les paquets d'électrons doivent contenir le maximum d'électrons possible. Le flux intermittent d'électrons équivaut à un courant de 1 à 2 mA.

Dans ce cas, les cathodes à émission de champ nécessitent de disposer de générateurs de polarisation capables de polariser la grille avec des impulsions électriques de l'ordre de la nanoseconde selon une amplitude suffisante pour atteindre la tension de seuil d'émission de la cathode. De telles impulsions électriques de grande amplitude et de faible durée s'avèrent difficiles à réaliser, et les puissances mises en jeu sont non négligeables à cause de la consommation d'énergie électrique dans l'élément capacitif constitué par la cathode à émission de champ elle-même dont les armatures sont constituées par la grille d'une part, et par le substrat et les micropointes d'autre part. On notera que la puissance consommée dans cet élément capacitif augmente comme le carré de la tension alternative appliquée à ses bornes, et est proportionnelle à sa fréquence.

Le problème proposé par la présente invention est de concevoir une nouvelle structure de générateur impulsionnel d'électrons à cathode à émission de champ permettant de réduire sensiblement la puissance mise en jeu en régime impulsionnel, et permettant de faciliter considérablement la commande de la cathode par un générateur d'impulsions électriques plus facile à réaliser.

Un autre objet de l'invention est d'améliorer le régime impulsionnel du générateur d'électrons, en réduisant la durée des fronts de montée et de descente des impulsions d'électrons.

Pour atteindre ces objets ainsi que d'autres, l'invention prévoit un générateur impulsionnel d'électrons, comprenant une cathode à émission de champ à micropointes émettrices d'électrons associées à une grille polarisée par des moyens de polarisation positive de grille, avec une anode attirant les électrons émis par la cathode, et dans lequel les moyens de polarisation positive de grille génèrent une tension de polarisation de grille ayant :
- une valeur de tension de repos qui, pendant les étapes de non émission d'électrons, reste seulement légèrement inférieure à la tension de polarisation active de grille à partir de laquelle l'anode reçoit un flux non négligeable d'électrons provenant de la cathode,
- une valeur de tension d'émission qui, pendant les étapes d'émission d'électrons, est supérieure à ladite tension de polarisation active de grille.

On comprend que, entre l'étape de non émission d'électrons et l'étape d'émission d'électrons, la valeur de tension de polarisation est modifiée selon une amplitude égale à la différence entre la valeur de tension d'émission et la valeur de tension de repos. Cette amplitude est donc une fraction seulement de la valeur de tension d'émission. La puissance mise en jeu à chaque cycle impulsionnel est donc fortement réduite, puisque seule cette différence entre la tension d'émission et la tension de repos intervient dans le calcul de la puissance, et intervient au carré. Egalement, il est plus facile de réaliser une impulsion à fronts raides dont l'amplitude est égale seulement à la différence entre la tension d'émission et la tension de repos. Cela simplifie la réalisation du générateur de polarisation de grille, et cela améliore la forme d'onde du paquet d'électrons émis par le générateur.

Selon un mode de réalisation, la valeur de tension de repos est légèrement inférieure à la tension de seuil d'émission de la cathode. On réalise ainsi un générateur dont la structure est particulièrement simple, ne comportant aucun élément autre que ceux habituellement utilisés dans les cathodes à émission de champ à micropointes émettrices d'électrons.

En alternative ou en complément, on peut prévoir une grille répulsive transparente interposée entre la grille de cathode et l'anode, polarisée légèrement au-dessous de la tension de seuil d'émission de la cathode, pour repousser vers la cathode les flux d'électrons ayant une énergie insuffisante pendant les étapes de non émission d'électrons, et pour laisser passer les flux d'électrons ayant une énergie suffisante pendant les étapes d'émission d'électrons.

Cela permet d'inhiber de façon plus certaine toute émission d'électrons lors des étapes de non émission, et éventuellement d'utiliser une tension de repos légèrement supérieure pour la polarisation permanente de grille.

En pratique, on peut prévoir que les moyens de polarisation positive de grille génèrent une tension de polarisation de grille comprenant une tension de prépolarisation positive permanente à laquelle est superposée une composante impulsionnelle positive de tension de polarisation.

Pour réaliser de façon simple le générateur de polarisation de grille, les moyens de polarisation positive de grille peuvent comprendre un générateur de tension de prépolarisation positive permanente, délivrant ladite tension de prépolarisation positive permanente, en série avec un générateur de tension impulsionnelle positive délivrant ladite composante impulsionnelle positive de tension de polarisation.

De préférence, ladite composante impulsionnelle positive de tension de polarisation a une amplitude de quelques volts seulement. En effet, il est facile de générer une impulsion ayant une durée de une nanoseconde et une amplitude d'environ 10 volts.

Le flux d'électrons émis par de tels générateurs a sensiblement la même allure que le signal constitué par ladite composante impulsionnelle positive de tension de polarisation.

D'autres objets, caractéristiques et avantages de la présente invention ressortiront de la description suivante de modes de réalisation particuliers, faite en relation avec les figures jointes, parmi lesquelles:
- la figure 1 est une vue schématique montrant un générateur impulsionnel d'électrons selon un mode de réalisation de la présente invention;
- la figure 2 illustre les caractéristiques tension / courant d'une cathode à émission de champ ; et
- la figure 3 illustre la constitution de la tension de polarisation de grille, et le courant électrique correspondant au flux d'électrons qui en résulte.

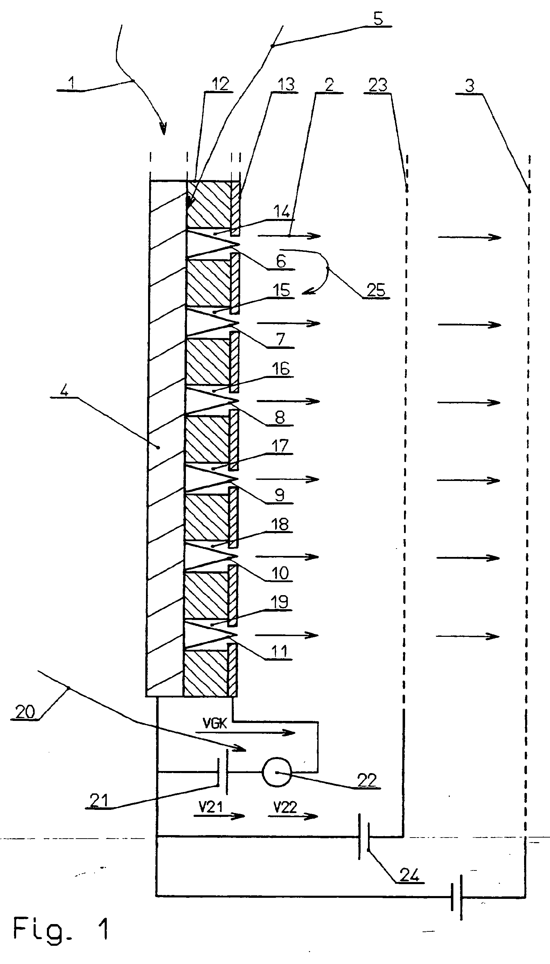

En se référant à la figure 1, un générateur impulsionnel d'électrons selon la présente invention comprend une cathode à émission de champ 1, pour générer un flux d'électrons 2 en direction d'une anode 3.

La cathode à émission de champ 1 comprend, de façon connue, un substrat conducteur 4, par exemple en silicium, ayant une face active 5 sur laquelle sont disposées des micropointes 6-11. La face active 5 est recouverte d'une couche isolante 12, par exemple en oxyde de silicium, la séparant d'une grille 13 conductrice. Les micropointes 6-11 sont logées dans des cavités respectives 14-19 ménagées dans la couche isolante 12 et communiquant en direction de l'anode 3 par des ouvertures correspondantes prévues dans la grille 13. Les pointes des micropointes 6-11 viennent en affleurement de la surface de grille 13.

La dimension des cavités 14-19, et donc la dimension des micropointes 6-11, est de l'ordre du micron en hauteur et en largeur. On réalise généralement des réseaux de micropointes dont la densité est de l'ordre de 10 000 à 100 000 micropointes par mm².

Des moyens de polarisation positive de grille 20 sont connectés entre le substrat 4 et la grille 13, pour assurer la polarisation positive de la grille 13.

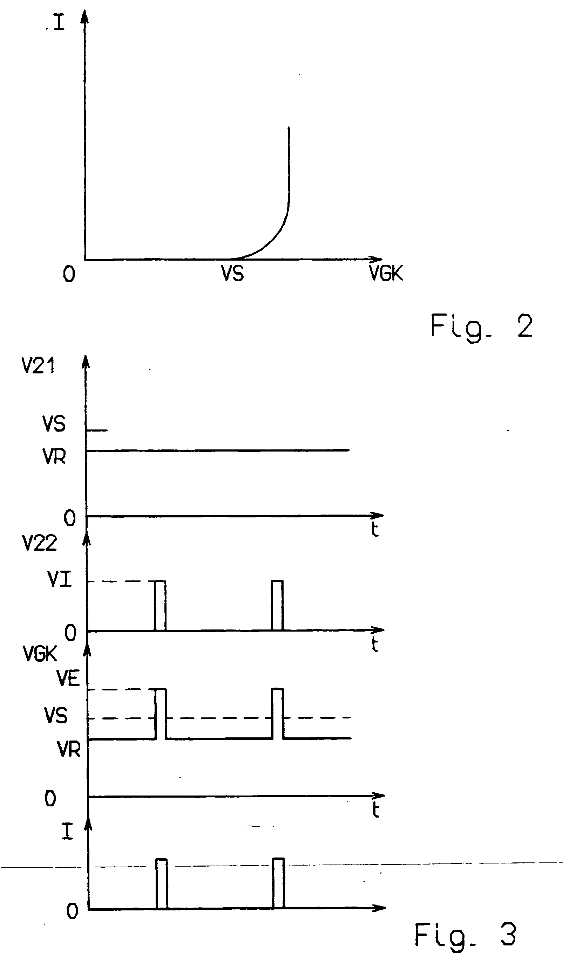

Dans la réalisation illustrée sur la figure, les moyens de polarisation positive de grille 20 comprennent un générateur de tension de prépolarisation positive permanente 21, délivrant une tension de prépolarisation positive permanente V21, en série avec un générateur de tension impulsionnelle positive 22 délivrant une composante impulsionnelle positive V22 de tension de polarisation. Par exemple, la figure 3 illustre la tension de prépolarisation positive permanente V21, sous forme d'une tension continue VR, et la composante impulsionnelle V22 positive de tension de polarisation, sous forme d'impulsions rectangulaires d'amplitude VI.

Le troisième graphe de la figure 3 illustre la tension de polarisation de grille VGK résultant de la somme de la tension V21 et de la tension V22, et comportant une valeur de tension de repos VR et une valeur de tension d'émission VE, avec VE = VR + VI.

En se référant à la figure 2, illustrant la caractéristique courant / tension d'une cathode à émission de champ, on voit que le courant électrique I correspondant au flux d'électrons émis par la cathode est nul tant que la tension de polarisation de grille VGK est inférieure à un seuil d'émission VS de la cathode. Au-delà du seuil d'émission VS, la tension de polarisation VGK de la grille par rapport à la cathode produit un courant d'électrons I qui augmente exponentiellement en fonction de la tension. La tension de seuil VS est généralement de l'ordre de 50 à 100 volts, dépendant de la constitution du réseau de micropointes de la cathode.

Selon la présente invention, on choisit une valeur de tension de repos VR qui, pendant les étapes de non émission d'électrons, reste seulement légèrement inférieure à la tension de polarisation active VA de grille 13. On définit la tension de polarisation active VA de grille 13 comme étant la tension de polarisation VGK à partir de laquelle l'anode 3 reçoit un flux non négligeable d'électrons provenant de la cathode 1. Et on choisit une valeur de tension d'émission VE qui, pendant les étapes d'émission d'électrons, est supérieure à ladite tension de polarisation active VA de grille 13.

Selon un mode de réalisation simplifié, on choisit comme valeur de tension de polarisation active VA la tension de seuil d'émission VS de la cathode 1. En pratique, la valeur de tension de repos VR peut alors être choisie légèrement inférieure à la tension de seuil d'émission VS de la cathode 1.

Si nécessaire, pour annuler de façon certaine le flux d'électrons pendant les périodes de repos, on peut également prévoir une grille répulsive transparente 23 telle qu'illustrée sur la figure 1. La grille répulsive transparente 23 est interposée dans le flux d'électrons entre la grille 13 de cathode et l'anode 3, et est polarisée par un générateur 24 légèrement au-dessous de la tension de seuil d'émission VS de la cathode 1. Ainsi, la grille répulsive transparente 23 repousse vers la cathode 1 les flux d'électrons 25 ayant une énergie insuffisante pendant les étapes de non émission d'électrons, tandis qu'elle laisse passer les flux d'électrons 2 ayant une énergie suffisante conférée par la tension de polarisation d'émission VE pendant les étapes d'émission d'électrons.

Dans ce mode de réalisation à grille répulsive transparente 23, on peut choisir une tension de polarisation active VA légèrement supérieure à la tension de seuil d'émission VS de la cathode 1.

Dans tous les modes de réalisation, on trouve avantage à prévoir une composante impulsionnelle positive V22 de tension de polarisation dont l'amplitude VI est de quelques volts seulement.

Un générateur impulsionnel d'électrons selon l'invention peut avantageusement être utilisé comme source d'électrons dans un spectromètre de masse à temps de vol.

La présente invention n'est pas limitée aux modes de réalisation qui ont été explicitement décrits, mais elle en inclut les diverses variantes et généralisations qui sont à la portée de l'homme du métier.

## Revendications

1. - Générateur impulsionnel d'électrons, comprenant une cathode à émission de champ (1) à micropointes émettrices d'électrons (6-11) associées à une grille (13) polarisée par des moyens de polarisation positive de grille (20), avec une anode (3) attirant les électrons émis par la cathode (1), **caractérisé en ce que** les moyens de polarisation positive de grille (20) génèrent une tension de polarisation de grille (VGK) ayant :
- une valeur de tension de repos (VR) qui, pendant les étapes de non émission d'électrons, reste seulement légèrement inférieure à la tension de polarisation active de grille (13) à partir de laquelle l'anode (3) reçoit un flux non négligeable d'électrons provenant de la cathode (1),
- une valeur de tension d'émission (VE) qui, pendant les étapes d'émission d'électrons, est supérieure à ladite tension de polarisation active de grille (13).

2. - Générateur selon la revendication 1, **caractérisé en ce que** ladite valeur de tension de repos (VR) est légèrement inférieure à la tension de seuil d'émission (VS) de la cathode (1).

3. - Générateur selon l'une des revendications 1 ou 2, **caractérisé en ce qu'**une grille répulsive transparente (23) est interposée entre la grille (13) de cathode et l'anode (3), polarisée légèrement au-dessous de la tension de seuil d'émission (VS) de la cathode (1), pour repousser vers la cathode (1) les flux d'électrons (25) ayant une énergie insuffisante pendant les étapes de non émission d'électrons, et pour laisser passer les flux d'électrons (2) ayant une énergie suffisante pendant les étapes d'émission d'électrons.

4. - Générateur selon l'une quelconque des revendications 1 à 3, **caractérisé en ce que** les moyens de polarisation positive de grille (20) génèrent une tension de polarisation de grille (VGK) comprenant une tension de prépolarisation positive permanente (V21) à laquelle est superposée une composante impulsionnelle positive (V22) de tension de polarisation.

5. - Générateur selon la revendication 4, **caractérisé en ce que** les moyens de polarisation positive de grille (20) comprennent un générateur de tension de prépolarisation positive permanente (21), délivrant ladite tension de prépolarisation positive permanente (V21), en série avec un générateur de tension impulsionnelle positive (22) délivrant ladite composante impulsionnelle positive (V22) de tension de polarisation.

6. - Générateur selon l'une des revendications 4 ou 5, **caractérisé en ce que** ladite composante impulsionnelle positive (V22) de tension de polarisation a une amplitude (VI) de quelques volts seulement.

7. - Spectromètre de masse à temps de vol, **caractérisé en ce qu'**il comprend un générateur impulsionnel d'électrons selon l'une quelconque des revendications 1 à 6.

## Claims

1. A pulse mode electron generator including a field emission cathode (1) with electron-emitting micropoints (6-11) associated with a grid (13) biased by means (20) for positively biasing the grid and an anode (3) attracting electrons emitted by the cathode (1), **characterized in that** the means (20) for positively biasing the grid generate a grid bias voltage (VGK) taking:
- a rest voltage value (VR) which, during non-emission of electrons, remains only slightly lower than the active bias voltage of the grid (13) from which the anode (3) receives a non-negligible flow of electrons from the cathode (1), or
- an emission voltage value (VE) which, during emission of electrons, is higher than said active bias voltage of the grid (13).

2. A generator according to claim 1, **characterized in that** said rest voltage (VR) is slightly lower than the emission threshold voltage (VS) of the cathode (1).

3. A generator according to either claim 1 or claim 2, **characterized in that** a transparent repulsive grid (23) is placed between the cathode grid (13) and the anode (3) and is biased to a voltage slightly lower than the emission threshold voltage (VS) of the cathode (1) in order to repel towards the cathode (1) electrons (25) having insufficient energy during non-emission of electrons and to allow through electrons (2) having sufficient energy during emission of electrons.

4. A generator according to any one of claims 1 to 3, **characterized in that** the means (20) for positively biasing the grid generate a grid bias voltage (VGK) comprising a permanent positive pre-bias voltage (V21) on which is superimposed a positive bias voltage pulse component (V22).

5. A generator according to claim 4, **characterized in that** the means (20) for positively biasing the grid include a permanent positive pre-bias voltage generator (21) delivering said permanent positive pre-bias voltage (V21) and in series with a positive pulse voltage generator (22) delivering said positive bias voltage pulse component (V22).

6. A generator according to either claim 4 or claim 5, **characterized in that** said positive bias voltage pulse component (V22) has an amplitude (VI) of only a few volts.

7. A time-of-flight mass spectrometer, **characterized in that** it includes a pulse mode electron generator according to any of claims 1 to 6.

## Patentansprüche

1. - Gepulster Elektronenstrahlgenerator, der eine Feldemissionskatode (1) mit Elektronen emittierenden Mikrospitzen (6-11) verbunden mit einem durch Mittel zur positiven Gittervorspannung (20) polarisierten Gitter (13) enthält, mit einer die von der Katode (1) emittierten Elektronen anziehenden Anode (3), **dadurch gekennzeichnet, dass** die Mittel zur positiven Gittervorspannung (20) eine Gitterpolarisationsspannung (VGK) erzeugen, die:
- einen Ruhespannungswert (VR) hat, der während der Elektronen-Nichtemissionsphasen nur leicht unter der aktiven Gitterpolarisationsspannung (13) bleibt, ausgehend von der die Anode (3) einen nicht unwesentlichen von der Katode (1) stammenden Elektronenfluss erhält,
- einen Emissionsspannungswert (VE) hat, der während der Elektronenemissionsphasen über dieser aktiven Gitterpolarisationsspannung (13) liegt.

2. - Generator gemäß Anspruch 1, **dadurch gekennzeichnet, dass** dieser Ruhespannungswert (VR) leicht niedriger als die Emissionsschwellenspannung (VS) der Katode (1).

3. - Generator gemäß einem der Ansprüche 1 oder 2, **dadurch gekennzeichnet, dass** zwischen Katodengitter (13) und Anode (3) ein transparentes Abstoßungsgitter (23) eingefügt wird, das leicht unter der Emissionsschwellenspannung (VS) der Katode (1) polarisiert ist, um während der Elektronen-Nichtemissionsphasen diejenigen Elektronenflüsse (25), die eine unzureichende Energie haben, zur Katode (1) zurückzutreiben, und während der Elektronen-Emissionsphasen diejenigen Elektronenflüsse (2) durchzulassen, die eine ausreichende Energie besitzen.

4. - Generator gemäß einem der Ansprüche 1 bis 3, **dadurch gekennzeichnet, dass** die Mittel zur positiven Gittervorspannung (20) eine Gitterpolarisationsspannung (VGK) erzeugen, die eine permanente positive Vorpolarisationsspannung (V21) enthält, die mit einer positiven Polarisationsspannungsimpulskomponente (V22) überlagert wird.

5. - Generator gemäß Anspruch 4, **dadurch gekennzeichnet, dass** die Mittel zur positiven Gittervorspannung (20) einen Generator für permanente positive Vorpolarisationsspannung (21) enthalten, der diese permanente positive Vorpolarisationsspannung (V21) abgibt, in Reihe mit einem Generator für positive Impulsspannung (22), der diese positive Polarisationsspannungsimpulskomponente (V22) abgibt.

6. - Generator gemäß einem der Ansprüche 4 oder 5, **dadurch gekennzeichnet, dass** diese positive Polarisationsspannungsimpulskomponente (V22) eine Amplitude (VI) von nur wenigen Volt hat.

7. - Flugzeit-Massenspektrometer, **dadurch gekennzeichnet, dass** es einen gepulsten Elektronenstrahlgenerator gemäß einem beliebigen der Ansprüche 1 bis 6 enthält.
